# DEMANDE DE BREVET EUROPEEN

(11) **EP 1 398 488 A1**
(43) Date de publication de la demande: **17.03.2004**
(21) Numéro de dépôt: 03292210.6
(22) Date de dépôt: 09.09.2003
(51) Int. Cl.: F02D 41/20, H01L 41/04

(54) **Dispositif et procédé de commande d'injecteur piézo-électrique**

(30) Priorité: 13.09.2002 FR 0211378
(71) Demandeur: Renault S.A., 92100 Boulogne Billancourt (FR)
(72) Inventeur: Ripoll, Christophe, 78220 Viroflay (FR)

(57) **Abrégé**

Dispositif de commande 1 d'au moins un injecteur 3 équipé d'au moins un transducteur apte à se déplacer à réception d'une commande électrique, comprenant un étage de découpage 7 pourvu d'un interrupteur 15 et de moyens d'aide à la commutation dudit interrupteur, et un étage de sélection 9 d'un transducteur.

## Description

L'invention se rapporte au domaine de la commande d'injection de carburant pour moteur à combustion interne destiné par exemple à équiper un véhicule automobile.

L'invention concerne plus particulièrement une commande d'injection de carburant permettant d'atomiser le carburant injecté sous forme de très fines gouttelettes.

Les dispositifs d'injection de carburant utilisés aujourd'hui sur les moteurs à combustion interne équipant les véhicules automobiles ou routiers, fonctionnent classiquement sur le modèle d'une vanne dont on commande en permanence l'état ouvert ou fermé, le dosage du carburant injecté se faisant alors directement par le temps d'ouverture.

De tels systèmes d'injection comprennent une pompe électrique d'alimentation en carburant qui alimente, par le canal d'une rampe de distribution, l'ensemble des injecteurs sous une pression présentant une différence constante avec la pression régnant dans le collecteur d'admission grâce à un régulateur de pression. En contrôlant électroniquement l'électro-aimant actionnant la soupape de chaque injecteur, on commande le début et la durée d'ouverture de celle-ci et on détermine alors un débit précis de carburant pour chacun des injecteurs. Ainsi, la quantité de carburant injectée dépend uniquement du temps d'ouverture des électro-injecteurs.

Les injecteurs du type à aiguille commandée électromagnétiquement, qui sont les plus communément employés, présentent toutefois des limites qui freinent l'amélioration des performances des moteurs, notamment en terme de dépollution. En particulier, les temps mis pour ouvrir ou fermer les aiguilles sont encore trop élevés, environ 1 à 2 ms, ce qui empêche de répartir correctement l'injection sur tout le temps d'ouverture de la soupape. De plus, le temps minimum d'ouverture, qui détermine la dose minimale de carburant pouvant être injecté, est encore trop important pour certains points de fonctionnement du moteur.

Les injecteurs à aiguille connus présentent par ailleurs des orifices d'injection de diamètres relativement importants pour permettre de débiter les quantités requises de carburant pour les fonctionnements à pleine charge et hauts régimes des moteurs. Cette disposition génère des jets de carburant présentant des gouttes de fortes dimensions, ce qui freine la vaporisation du carburant (et donc la préparation du mélange carburé) et est à même de favoriser le phénomène de mouillage de paroi.

En effet, le carburant non vaporisé tend à se déposer sur les parois du conduit d'admission ou de la chambre de combustion en injection directe. Un tel dépôt entraîne des problèmes de dosage, particulièrement aigus dans les transitoires par manque de connaissance de la quantité de carburant qui rentre effectivement dans la chambre de combustion correspondante. Ce phénomène de mouillage des parois est l'une des causes importantes des fortes émissions de polluants lors des démarrages à froid des moteurs.

Par ailleurs, avec un injecteur classique à aiguille, à l'ouverture de l'aiguille lorsque cette dernière commence à quitter son siège, il se forme une bulle de liquide qui disparaît lorsque l'aiguille est complètement levée, l'écoulement du fluide se régularisant alors. Ce changement dans la nature de l'écoulement rend impossible tout contrôle précis du débit instantané de l'injecteur.

Certains ont cherché à résoudre ces différents problèmes, en développant des injecteurs utilisant des actuateurs piézo-électriques pour manoeuvrer l'aiguille de façon à abaisser la durée d'ouverture et de fermeture de l'aiguille, mais de tels systèmes qui fonctionnent toujours selon le principe d'une vanne, conservent des inconvénients importants liés notamment à la dispersion importante affectant la taille des gouttes dans le jet de carburant au sortir du nez de l'injecteur.

L'ensemble des problèmes cités précédemment se solde donc par une vaporisation du carburant pouvant être incomplète et non homogène lors de la préparation du mélange carburé dans la chambre de combustion, des dosages imprécis, avec pour conséquence une combustion incomplète se traduisant par la formation d'une quantité élevée de gaz polluants et un déficit énergétique altérant le rendement du moteur.

Le document FR-A-2 801 346 décrit un dispositif d'injection de carburant pour moteur à combustion interne équipé d'un injecteur comportant une buse alimentée en carburant et à l'extrémité de laquelle est ménagé un orifice d'injection, des moyens de mise en vibration cyclique de la buse tels qu'un transducteur piloté en durée et en intensité par le système électronique de contrôle moteur, et des moyens obturateurs rappelés par des moyens élastiques de rappel contre l'extrémité de la buse, lesdits moyens élastiques de rappel étant formés par une tige traversant le corps de l'injecteur jusqu'à une cavité située à l'extrémité opposée par rapport à l'orifice d'injection, ladite tige coopérant avec une masse et des moyens d'amortissement logés dans ladite cavité, la mise en vibration de la buse et des moyens obturateurs assurant l'éjection d'une quantité de carburant prédéterminée.

L'invention propose un dispositif de commande permettant de tirer le meilleur parti d'un tel injecteur.

L'invention propose un dispositif de commande d'injecteur permettant une combustion optimale du carburant injecté en restant de structure simple et économique, le dispositif de commande étant à faible consommation.

Le dispositif de commande, selon un aspect de l'invention, est destiné à au moins un injecteur équipé d'au moins un transducteur apte à se déplacer à réception d'une commande électrique, le dispositif comprenant un étage de découpage pourvu d'au moins un interrupteur et de moyens d'aide à la commutation dudit interrupteur, et un étage de sélection d'un transducteur. Les pertes de l'interrupteur sont maintenues à un niveau faible, d'où une consommation faible et un refroidissement aisé.

De préférence, l'étage de découpage comprend une inductance en série avec l'interrupteur, entre l'entrée dudit étage de hachage et une masse. On évite ainsi les appels de courant excessifs.

L'inductance est, de préférence, dimensionnée de telle sorte que le potentiel aux bornes dudit interrupteur puisse osciller par résonance entre la capacité équivalente de l'interrupteur et l'inductance. La capacité équivalente de l'interrupteur peut être augmentée par ajout d'un condensateur. L'oscillation peut se produire à la fin de la conduction d'une diode d'une autre branche de l'étage de découpage. L'inductance et la capacité forment ainsi un moyen pour fermer l'interrupteur à tension quasi nulle.

Dans un mode de réalisation de l'invention, les moyens d'aide à la commutation comprennent un condensateur en parallèle avec l'interrupteur. On dimensionne ledit condensateur de façon qu'une résonance soit permise amenant la tension aux bornes dudit interrupteur à une valeur presque nulle lors de sa fermeture.

Avantageusement, les moyens d'aide à la commutation comprennent une diode en antiparallèle avec l'interrupteur. On peut ainsi limiter la tension inverse de l'interrupteur à la tension de la diode à l'état passant qui est très faible, souvent de l'ordre de 0,7 volt. L'interrupteur peut être dimensionné pour une tension inverse faible ce qui intéressant économiquement.

Dans un mode de réalisation de l'invention, l'étage de découpage comprend une deuxième branche parallèle à l'interrupteur et comprenant une diode et un condensateur de filtrage montés en série, la sortie de l'étage de découpage étant prise au point commun entre la diode et le condensateur de la deuxième branche.

Dans un mode de réalisation de l'invention, le dispositif comprend un deuxième étage comprenant une inductance et un interrupteur électronique montés en série, le point commun à l'inductance et à l'interrupteur formant la sortie du deuxième étage, l'autre borne de l'inductance formant l'entrée du deuxième étage, et l'autre borne de l'interrupteur étant reliée à la masse.

De préférence, l'étage de sélection comprend, pour chaque transducteur, un interrupteur électronique monté en série avec ledit transducteur.

Dans un mode de réalisation de l'invention, une pluralité de transducteurs sont montés en parallèle.

Dans un mode de réalisation de l'invention, le dispositif comprend un calculateur apte à commander des composants de puissance. Le calculateur peut être apte à commander la fermeture de l'interrupteur du deuxième étage lorsque la diode en antiparallèle est passante. La détection de la conduction de la diode en antiparallèle peut être effectuée par détection de la tension du passage à zéro de la tension aux bornes dudit interrupteur.

De préférence, on utilisera l'interrupteur de l'étage de découpage en mode de conduction discontinu.

L'invention propose également un procédé de commande d'au moins un injecteur équipé d'au moins un transducteur apte à se déplacer à réception d'une commande électrique, dans lequel on découpe une tension d'alimentation avec au moins un interrupteur tout en aidant la commutation dudit interrupteur à zéro de tension, et on sélectionne un transducteur.

On peut aider la commutation d'un autre transistor d'un autre étage de puissance à zéro de tension, par exemple un transistor destiné à la modulation de largeur d'impulsions.

L'invention propose également un moteur à combustion interne comprenant au moins un injecteur équipé d'au moins un transducteur apte à se déplacer à réception d'une commande électrique et un dispositif de commande comprenant un étage de découpage pourvu d'au moins un interrupteur et de moyens d'aide à la commutation dudit interrupteur, et un étage de sélection d'un transducteur.

La présente invention sera mieux comprise à l'étude de la description détaillée de quelques modes de réalisation pris à titre d'exemples nullement limitatifs et illustrés par les dessins annexés, sur lesquels :
- la figure 1 est un schéma électrique d'un dispositif de commande selon un aspect de l'invention ;
- la figure 2 est un schéma électrique d'un dispositif de commande selon un autre aspect de l'invention ; et
- les figures 3 à 6 montrent des formes d'onde du dispositif de commande de la figure 1.

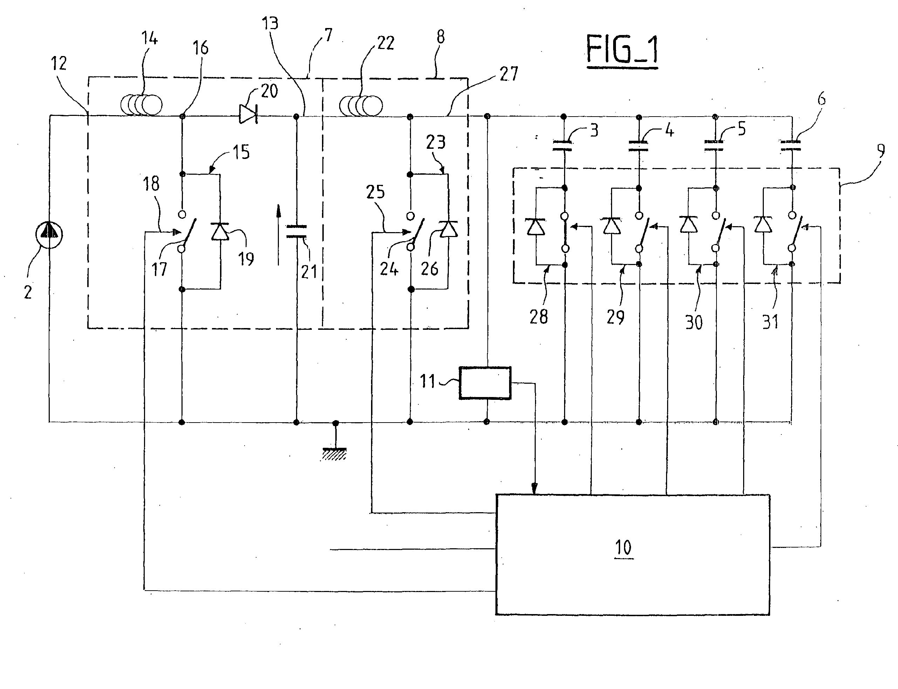

Comme on peut le voir sur la figure 1, un dispositif de commande 1 est alimenté par une source de tension 2, par exemple la batterie du véhicule dans lequel il est monté, ou plus généralement le réseau électrique du véhicule, par exemple de type continu 12 ou 42 volts ou encore de type alternatif.

Le dispositif de commande 1 est prévu pour alimenter quatre injecteurs piézo-électriques représentés par le même symbole qu'un condensateur en raison des caractéristiques électriques d'une cellule piézo-électrique qui est similaire à celle d'un condensateur et référencés 3 à 6.

Le dispositif de commande 1 proprement dit est équipé de trois étages de puissance référencés 7 à 9, d'un calculateur de pilotage 10 et d'un capteur de tension 11 disposé en sortie du deuxième étage 8 et dont la sortie est reliée au calculateur 10, le calculateur émettant des signaux de commande vers les étages de puissance 7 à 9.

Le premier étage 7, dit de découpage, comprend une entrée 12 reliée à la source de tension 2 et une sortie 13 reliée au deuxième étage 8. Le premier étage 7 comprend une inductance 14 reliée à l'entrée 12 et un interrupteur électronique 15 monté en série avec l'inductance 14, le point commun à l'inductance 14 et à l'interrupteur 15 étant noté 16, l'autre borne de l'interrupteur 15 étant reliée à la masse.

Tel qu'il est représenté en figure 1, l'interrupteur 15 comprend un transistor 17 pourvu d'une entrée de commande 18 et une diode 19 montées en antiparallèle. On pourrait, bien entendu, utiliser un transistor de type bidirectionnel. Dans le cas illustré, le transistor 17 pourrait être de type MOS.

Parallèlement à l'interrupteur 15, sont également montés une diode 20 et un condensateur 21 en série, la diode 20 étant reliée au point 16 et le condensateur 21 assure le filtrage de la tension. La sortie 13 du premier étage 7 est prise au point commun entre la diode 20 et le condensateur 21.

La diode 19 montée en antiparallèle du transistor 17 permet de limiter la tension inverse vue par le transistor 17 à la tension de la diode 19 à l'état passant qui est très faible, souvent de l'ordre de 0,7 volt. Grâce à cela, le transistor 17 est dimensionné pour une tension inverse faible et est donc moins onéreux.

Le deuxième étage 8 comprend une inductance 22 et un interrupteur électronique 23 montés en série entre l'entrée du deuxième étage 8 reliée à la sortie 13 du premier étage 7 et la masse. L'interrupteur 23 peut être d'un type analogue à l'interrupteur 15 avec un transistor 24 équipé d'une entrée de commande 25 et une diode 26 montée en antiparallèle. Le point commun entre l'inductance 22 et l'interrupteur électronique 23 forme la sortie 27 du deuxième étage 8. L'autre borne de l'interrupteur électronique 23 est reliée à la masse.

La sortie 27 du deuxième étage 8 est reliée à des premières bornes des injecteurs 3 à 6 qui sont montés électriquement en parallèle. Les bornes opposées des injecteurs 3 à 6 sont reliées au troisième étage 9.

Le troisième étage 9 comprend quatre interrupteurs électroniques 28 à 31, chacun monté en série respectivement avec un injecteur 3, 4, 5, 6. Chaque interrupteur électronique 28 à 31 comprend une structure analogue à celle de l'interrupteur 15, c'est-à-dire un transistor, par exemple de type MOS, et une diode montée en antiparallèle. Les bornes des interrupteurs électroniques 28 à 31 opposées aux injecteurs 3 à 6 sont reliées à la masse. Chaque entrée de commande des interrupteurs électroniques 28 à 31 est reliée au calculateur 10.

Le calculateur 10 reçoit en entrée une consigne de tension et est pourvu de six sorties destinées respectivement à l'entrée de commande 18 de l'interrupteur électronique 15 du premier étage 7, à l'entrée de commande 25 de l'interrupteur électronique 24 du deuxième étage 8 et aux entrées de commande des interrupteurs électroniques 28 à 31 du troisième étage 9.

Bien entendu, on comprend que le nombre d'injecteurs est lié au nombre de cylindres du véhicule automobile et sera donc généralement compris entre 1 et 12. Bien entendu, il est tout à fait possible de prévoir une pluralité d'injecteurs par cylindre.

Le dispositif de commande 1 permet de générer une haute tension périodique qui peut être supérieure à une centaine de volts à une fréquence élevée, typiquement supérieure à une dizaine de kiloHertz, sur la cellule piézo-électrique d'un injecteur à partir de la source de tension 2. Les interrupteurs 28 à 31 permettent de sélectionner l'injecteur qui doit être activé. L'interrupteur 15 du premier étage 7 permet d'effectuer un découpage d'une tension continue d'entrée et l'interrupteur 23 du deuxième étage 8 permet de déterminer une forme d'onde du type à modulation de largeur d'impulsions.

Le capteur 11 mesure la tension V₂₇ de sortie du deuxième étage 8 qui est égale à la tension vue par le transistor 24 et envoie au calculateur 10 le résultat de cette mesure. Le calculateur 10 élabore des ordres de commande du transistor 24 tels que la fermeture du transistor 24 a lieu à tension V₂₇ quasi nulle. On évite ainsi des pertes importantes de commutation à la fermeture du transistor 24 qui se produirait sous une tension non négligeable. On facilite ainsi le refroidissement du transistor 24.

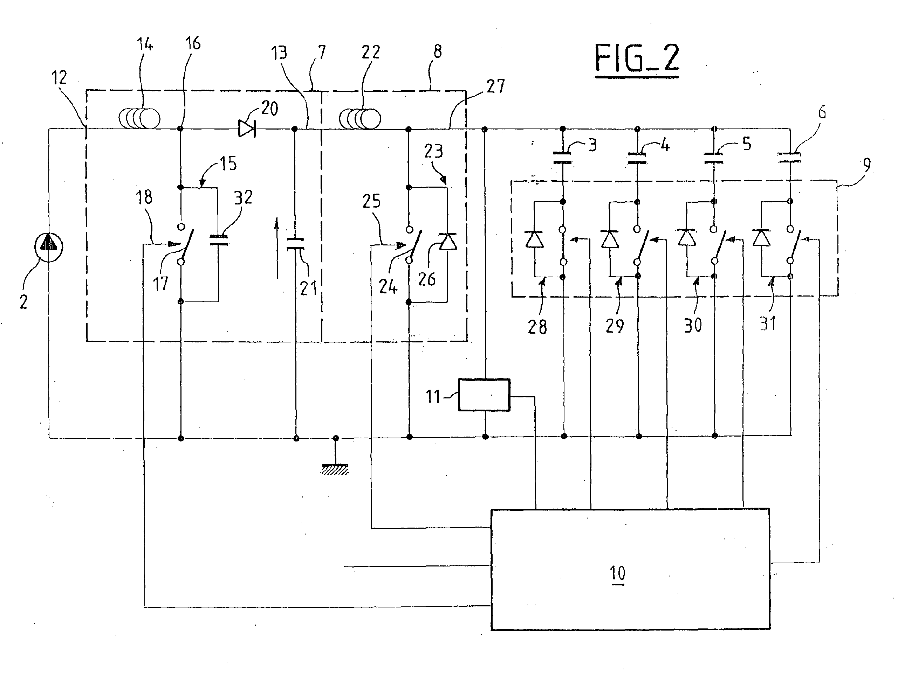

Sur la figure 2, les références semblables ont été conservées. La diode 19 est supprimée. Toutefois on comprendra que son maintien permet de cumuler les avantages du mode de réalisation précédent et ceux du mode de réalisation décrit ci-dessous.

Un condensateur 32 de capacité C₃₂ est monté parallèlement au transistor 17 et s'ajoute aux capacités parasites Cₚ₁₇ dudit transistor 17. La capacité équivalente est égale à C₁₇ = Cₚ₁₇ + C₃₂. La capacité C₃₂ est choisie de façon qu'une résonance soit possible entre l'inductance 14 et la capacité équivalente C₁₇, résonance amenant la tension aux bornes du transistor 17 à une valeur quasi nulle lors de sa fermeture. On évite ainsi des pertes importantes de commutation à la fermeture du transistor 17 qui se produirait sous une tension non négligeable. On facilite ainsi le refroidissement du transistor 17 dont l'échauffement est moindre.

Dans tous les modes de réalisation, y compris dans celui où un condensateur et une diode sont disposés en parallèle du transistor 17, on dimensionne l'inductance 14 de façon qu'à la fin de la conduction de la diode 20, le potentiel aux bornes du transistor 17 oscille librement par résonance pour obtenir un courant presque nul à la fermeture du transistor 17.

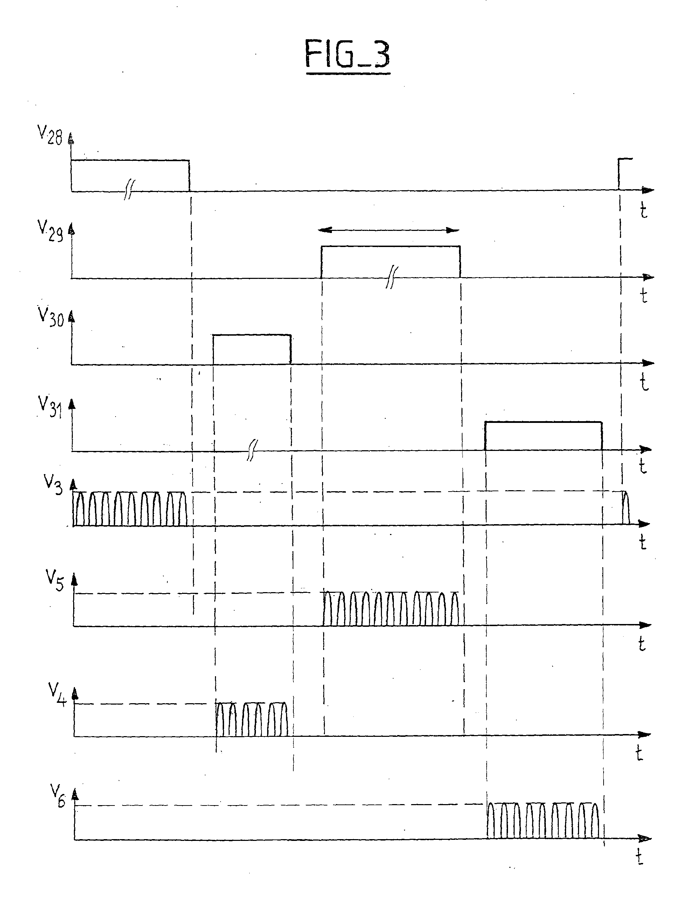

Sur la figure 3, la première courbe montre la tension V₂₈ sur l'entrée de commande de l'interrupteur 28, la deuxième courbe la tension V₂₉ sur l'entrée de commande de l'interrupteur 29, la troisième courbe la tension V₃₀ sur l'entrée de commande de l'interrupteur 30 et la quatrième courbe la tension V₃₁ sur l'entrée de commande de l'interrupteur 31.

Les tensions de commande se présentent sous la forme de créneaux, de largeur variable et de hauteur constante. En d'autres termes, la tension de commande est fixe et la durée de sélection des interrupteurs du troisième étage et donc de l'injecteur correspondant est variable. En outre, on prévoit qu'un seul injecteur est sélectionné en même temps et qu'une temporisation est prévue entre deux sélections d'injecteur.

La cinquième courbe montre la tension V₃ aux bornes de l'injecteur 3, la sixième courbe montre la tension V₄ aux bornes de l'injecteur 5, la septième courbe montre la tension V₅ aux bornes de l'injecteur 4 et la huitième courbe montre la tension V₆ aux bornes de l'injecteur 6.

Bien entendu, la tension aux bornes d'un injecteur est nulle tant que ledit injecteur n'est pas sélectionné. Lorsqu'un injecteur est sélectionné, par exemple l'injecteur 3, il voit une tension correspondant à l'alternance positive d'un signal sinusoïdal ou sensiblement sinusoïdal, lorsque l'interrupteur correspondant est passant.

Dans le mode de réalisation représenté ici, la fréquence et la tension du signal sinusoïdal sont fixes. Toutefois, il est avantageux, dans certains cas, de pouvoir faire varier la durée d'activation T, et/ou la fréquence du signal sinusoïdal, et/ou la tension du signal sinusoïdal.

En d'autres termes, la tension de la source 2 est transformée par les étages 7, 8 et 9, en une tension alternative aux bornes des injecteurs, caractérisée par la tension crête V, la fréquence F et la durée T, et, ceci pour chaque injecteur. La consigne reçue par le calculateur 10 peut être fournie par des lois de commande venant d'une autre couche logicielle ou d'un autre calculateur dont les valeurs dépendent de l'état du véhicule, notamment du moteur, de la vitesse, de l'accélération, etc., et du type de combustion désiré. L'interface 11 assure la modulation de la largeur d'impulsions de la tension d'alimentation de chaque injecteur.

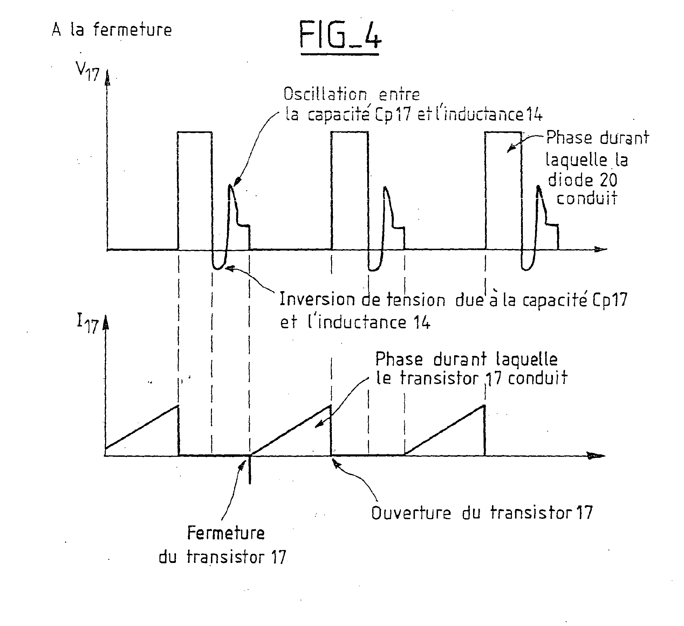

La première courbe de la figure 4 montre la tension V₁₇ aux bornes du transistor 17 et la deuxième courbe montre le courant I₁₇ dans le transistor 17, en l'absence de condensateur 32 et de dimensionnement adéquat. À la fermeture de la diode 20, se produit une inversion de la tension V₁₇ due à l'inductance 14 et à la capacité équivalente de l'interrupteur 15 augmentée ou non par un condensateur, puis une oscillation entre ces éléments. Le dimensionnement judicieux de l'inductance 14, de la capacité équivalente de l'interrupteur 15 augmentée ou non par un condensateur 32 permet de réduire le courant I₁₇ et la tension V₁₇ à des valeurs presque nulles.

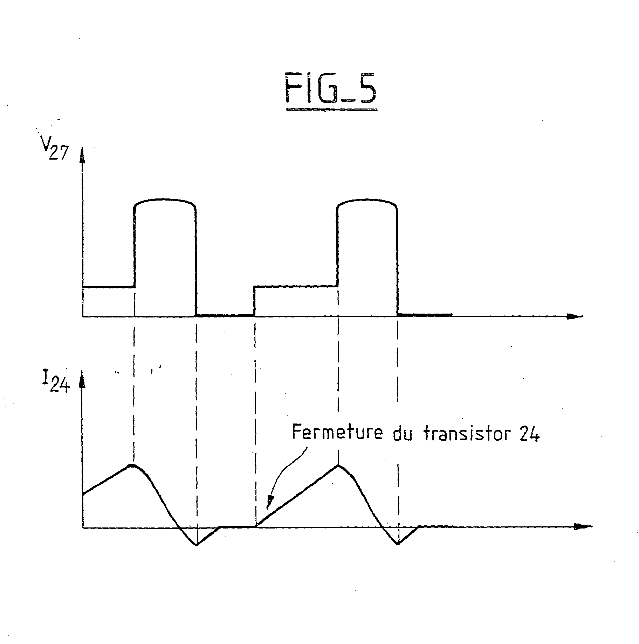

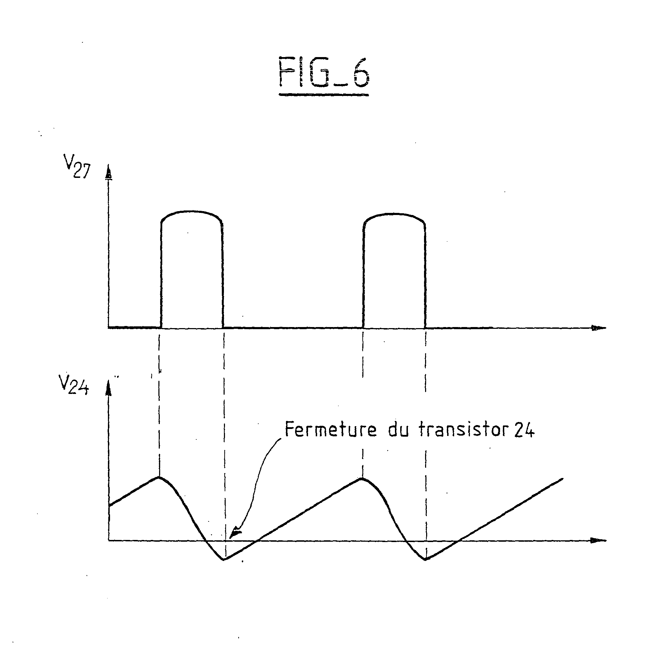

La première courbe de la figure 5 montre la tension V₂₇ aux bornes du transistor 24 et la deuxième courbe montre le courant I₂₄ dans le transistor 24, en l'absence de commande adéquate. À la fermeture du transistor 24, une contrainte importante réside dans la tension V₂₇ non nulle qui produit des pertes importantes. On prévoit alors un pilotage judicieux conforme aux courbes de la figure 6 dont la première courbe montre la tension V₂₇ aux bornes du transistor 24 et la deuxième courbe montre le courant I₂₄ dans le transistor 24. Grâce à la mesure de la tension par le capteur 11, le calculateur 10 émet un ordre de fermeture au transistor 24 légèrement plus tôt, à un instant où la tension à ses bornes est quasi nulle, par exemple car la diode 26 est passante. On réduit ainsi considérablement les pertes à la fermeture du transistor 24, d'où une réduction de l'énergie consommée et un refroidissement moins onéreux et plus simple.

L'interrupteur 23 est commandé de telle sorte qu'à sa fermeture, l'inductance 22 se charge pendant une certaine durée, puis lorsque ledit interrupteur 23 est bloqué, la tension aux bornes d'un injecteur sélectionné décrit une impulsion de forme sinusoïdale. La tension crête V₂₇ dépend de l'énergie emmagasinée dans l'inductance 22 et de la tension V₁₃ en entrée du deuxième étage 8. On fixe la durée de fermeture de l'interrupteur 15 de façon que la tension V₁₃ en entrée du deuxième étage 8 soit maintenue et que la tension V₂₇ de sortie du deuxième étage 8 soit obtenue par la commande de la durée de chargement de l'inductance 22. La tension V₂₇ en crête est donc une fonction des angles de conduction de l'interrupteur 23.

La tension V₁₈ présente une forme de créneaux qui assure, grâce au condensateur de filtrage 21, une tension V₁₃ de sortie du premier étage 7 continue. La tension V₁₃ peut être augmentée en augmentant les temps d'ouverture de l'interrupteur 15, vice-versa. La tension V₂₅ présente la forme de créneaux de largeur et d'intervalle variables, ce qui permet de faire varier la valeur crête de la tension V₂₇.

La consigne en tension est variable suivant les besoins du système et répercutée par le calculateur 10 en forme d'onde caractérisée par la tension crête d'excitation des cellules piézo-électriques des injecteurs 3 à 6. Toutefois, un pilotage en fréquence peut également présenter des avantages.

L'invention permet de contrôler la quantité de carburant injectée par des paramètres de contrôle électrique aux bornes des injecteurs dont les caractéristiques en débit de carburant sont fonction desdits paramètres de contrôle. La commande peut être déterminée pour réduire les pertes dans les composants actifs de puissance.

## Revendications

1. Dispositif de commande (1) d'au moins un injecteur (3) équipé d'au moins un transducteur apte à se déplacer à réception d'une commande électrique, **caractérisé par le fait qu'**il comprend un étage de découpage (7) pourvu d'au moins un interrupteur (15) et de moyens d'aide à la commutation dudit interrupteur, et un étage de sélection (9) d'un transducteur.

2. Dispositif selon la revendication 1, **caractérisé par le fait que** l'étage de découpage comprend une inductance (14) en série avec l'interrupteur, entre l'entrée dudit étage de découpage et une masse.

3. Dispositif selon la revendication 1 ou 2, **caractérisé par le fait que** les moyens d'aide à la commutation comprennent un condensateur (32) en parallèle avec l'interrupteur.

4. Dispositif selon l'une quelconque des revendications précédentes, **caractérisé par le fait que** les moyens d'aide à la commutation comprennent une diode (19) en antiparallèle avec l'interrupteur.

5. Dispositif selon l'une quelconque des revendications précédentes, **caractérisé par le fait que** l'étage de découpage comprend une deuxième branche parallèle à l'interrupteur (15) et comprenant une diode (20) et un condensateur de filtrage (21) montés en série, la sortie (13) de l'étage de découpage étant prise au point commun entre la diode et le condensateur de la deuxième branche.

6. Dispositif selon l'une quelconque des revendications précédentes, **caractérisé par le fait qu'**il comprend un deuxième étage (8) comprenant une inductance (22) et un interrupteur électronique (23) montés en série, le point commun à l'inductance et à l'interrupteur formant la sortie (27) du deuxième étage, l'autre borne de l'inductance formant l'entrée du deuxième étage, et l'autre borne de l'interrupteur étant reliée à la masse.

7. Dispositif selon l'une quelconque des revendications précédentes, **caractérisé par le fait que** l'étage de sélection comprend, pour chaque transducteur, un interrupteur électronique (28 à 31) monté en série avec ledit transducteur.

8. Dispositif selon la revendication 7, **caractérisé par le fait qu'**une pluralité de transducteurs sont montés en parallèle.

9. Dispositif selon l'une quelconque des ,revendications précédentes, **caractérisé par le fait qu'**il comprend un calculateur (10) apte à commander des composants de puissance.

10. Procédé de commande d'au moins un injecteur équipé d'au moins un transducteur apte à se déplacer à réception d'une commande électrique, dans lequel on découpe une tension d'alimentation avec au moins un interrupteur tout en aidant la commutation dudit interrupteur à zéro de tension, et on sélectionne un transducteur.

11. Procédé selon la revendication 10, dans lequel on aide la commutation d'un autre transistor d'un autre étage de puissance à zéro de tension.

12. Moteur à combustion interne comprenant au moins un injecteur (3) équipé d'au moins un transducteur apte à se déplacer à réception d'une commande électrique et un dispositif de commande (1) selon l'une quelconque des revendications 1 à 9.
